# EUROPEAN PATENT APPLICATION

(11) **EP 4 764 523 A1**
(43) Date of publication of application: **24.06.2026**
(21) Application number: 24886000.9
(22) Date of filing: 03.09.2024
(51) Int. Cl.: G01R 31/367, G01R 31/396, G01R 31/392, G01R 31/389, G01R 23/00

(54) **SOH PREDICTION DEVICE AND OPERATING METHOD THEREOF**

(30) Priority: 31.10.2023 KR 20230148220
(71) Applicant: LG Energy Solution, Ltd., Seoul 07335 (KR)
(72) Inventor: JO, Ha Jin, Daejeon 34122 (KR); KIM, Young Hwan, Daejeon 34122 (KR); KIM, Hyeon Su, Daejeon 34122 (KR)
(74) Representative: Plasseraud IP
(86) International application number: PCT/KR2024/013203
(87) International publication number: WO 2025/095320

(57) **Abstract**

A state of health (SOH) prediction device according to one embodiment disclosed herein may include a battery pack, an electrochemical impedance spectroscopy (EIS) data acquisition unit configured to acquire EIS data of the battery pack, a feature point identification unit configured to identify a plurality of feature points based on the EIS data, an angle parameter calculation unit configured to calculate an angle parameter related to impedance of the battery pack based on impedance related to the plurality of feature points, and an SOH prediction unit configured to acquire an SOH corresponding to the calculated angle parameter based on relationship data between a temperature at which the EIS data was acquired, the angle parameter, and an SOH of the battery pack.

## Description

### Technical Field

### CROSS-REFERENCE TO RELATED APPLICATION

This application claims priority to and the benefit of Korean Patent Application No. 10-2023-0148220 filed in the Korean Intellectual Property Office on October 31, 2023, the entire contents of which are incorporated herein by reference.

### TECHNICAL FIELD

Embodiments disclosed herein relate to a state of health (SOH) prediction device and a method of operating the same.

### Background Art

Recently, research and development on secondary batteries has been actively conducted. Here, the secondary battery is a battery capable of charging and discharging and includes all of conventional Ni/Cd batteries, Ni/MH batteries, etc. and recent lithium ion batteries. Among the secondary batteries, lithium-ion batteries have an advantage of having much higher energy density than conventional Ni/Cd batteries and Ni/MH batteries. In addition, the lithium-ion batteries may be made smaller and lighter and thus are used as a power source for mobile devices and recently, are attracting attention as next-generation energy storage media due to the expansion of the range of usage to a power source for electric vehicles.

A battery exchange system is present as a service related to these secondary batteries. The battery exchange system may provide users with a service that exchanges a discharged battery with a charged battery.

Such a battery exchange system may use a method of predicting a lifetime of a battery used for service. For example, an electrochemical impedance spectroscopy (EIS) may be used as a method for measuring the lifetime of a battery.

### Disclosure

### Technical Problem

One embodiment disclosed herein is directed to providing a state of health (SOH) prediction device for predicting a SOH of a battery pack based on an angle parameter related to impedance of the battery pack, and a method of operating the same.

The objects of the embodiments disclosed herein are not limited to the above-described objects, and other objects that are not described will be able to be clearly understood by those skilled in the art from the following description.

### Technical Solution

A state of health (SOH) prediction device according to one embodiment disclosed herein may include a battery pack, an electrochemical impedance spectroscopy (EIS) data acquisition unit configured to acquire EIS data of the battery pack, a feature point identification unit configured to identify a plurality of feature points based on the EIS data, an angle parameter calculation unit configured to calculate an angle parameter related to impedance of the battery pack based on impedance related to the plurality of feature points, and an SOH prediction unit configured to predict an SOH corresponding to the calculated angle parameter based on relationship data between a temperature at which the EIS data was acquired, the angle parameter, and an SOH of the battery pack.

According to one embodiment, the EIS data may include data on an EIS graph shown by dividing the impedance of the battery pack into a real part and an imaginary part, and a first feature point and a second feature point among the plurality of feature points are related to whether there is an inflection point in the EIS graph in a reference frequency region higher than a frequency corresponding to a maximum point among a plurality of points identified based on the EIS graph.

According to one embodiment, when the inflection point is not present in the reference frequency region, the first feature point may be related to a point where a real part value of the impedance is the smallest among the plurality of points identified based on the EIS graph, and the second feature point may be related to a point where an imaginary part value of the impedance is zero or a point having a frequency lower than a frequency corresponding to the point where the imaginary part value is zero among the plurality of points identified based on the EIS graph.

According to one embodiment, when the inflection point is not present in the reference frequency region, the first feature point may be related to a point where an imaginary part value of the impedance is zero among the plurality of points identified based on the EIS graph, and the second feature point may be related to a point having a frequency lower than a frequency corresponding to the first feature point among the plurality of points identified based on the EIS graph.

According to one embodiment, when the inflection point is present in the reference frequency region, the first feature point may be related to a point where a real part value of the impedance is the smallest among the plurality of points identified based on the EIS graph, and the second feature point may be related to the inflection point or a point having a frequency lower than a frequency corresponding to the inflection point among the plurality of points identified based on the EIS graph.

According to one embodiment, when the inflection point is present in the reference frequency region, the first feature point may be related to the inflection point, and the second feature point may be related to points corresponding to a frequency lower than a frequency corresponding to the inflection point.

According to one embodiment, when the inflection point is present in the reference frequency region, the first feature point may be related to a point where an imaginary part value of the impedance is zero among the plurality of points identified based on the EIS graph, and the second feature point may be related to the inflection point or points corresponding to a frequency lower than a frequency corresponding to the inflection point.

According to one embodiment, the angle parameter may be related to an angle between a straight line connecting the second feature point to the first feature point and one coordinate axis of the EIS graph.

According to one embodiment, the EIS data may include data on an EIS graph shown at a frequency corresponding to the second feature point and in a frequency region higher than a frequency corresponding to the second feature point.

According to one embodiment, the SOH prediction device may further include a relationship data generation unit configured to generate the relationship data, and a memory configured to store the relationship data, wherein the relationship data may be generated based on first EIS data acquired from a reference battery pack at a first temperature under a preset first condition and second EIS data acquired from the reference battery pack at a reference SOH under a preset second condition.

According to one embodiment, the preset first condition may include a specified state of charge (SOC) condition and a specified SOH condition in an idle section of the reference battery pack, and the preset second condition may include a specified SOC condition and a specified temperature condition in the idle section of the reference battery pack.

According to one embodiment, the relationship data generation unit may generate a function representing a tendency between a plurality of temperatures included in the first temperature and an angle parameter corresponding to each of the plurality of temperatures based on the first EIS data.

According to one embodiment, the relationship data generation unit may acquire a plurality of temperatures included in the first temperature and an angle parameter corresponding to each of a plurality of SOHs included in the reference SOH based on the first EIS data and the second EIS data and generate a function representing a tendency between the angle parameter and the plurality of SOHs at the first temperature.

A method of operating a state of health (SOH) prediction device according to one embodiment disclosed herein may include acquiring electrochemical impedance spectroscopy (EIS) data of a battery pack, identifying a plurality of feature points based on the EIS data, calculating an angle parameter related to impedance of the battery pack based on impedance related to the plurality of feature points, and predicting an SOH corresponding to the calculated angle parameter based on relationship data between a temperature at which the EIS data was acquired, the angle parameter, and an SOH of the battery pack.

According to one embodiment, the EIS data may include data on an EIS graph shown by dividing the impedance of the battery pack into a real part and an imaginary part, and a first feature point and a second feature point among the plurality of feature points may be related to whether there is an inflection point in the EIS graph in a reference frequency region higher than a frequency corresponding to a maximum point among a plurality of points identified based on the EIS graph.

According to one embodiment, when the inflection point is not present in the reference frequency region, the first feature point may be related to a point where a real part value of the impedance is the smallest among the plurality of points identified based on the EIS graph, and the second feature point may be related to a point where an imaginary part value of the impedance is zero or a point having a frequency lower than a frequency corresponding to the point where the imaginary part value is zero among the plurality of points identified based on the EIS graph, and when the inflection point is not present in the reference frequency region, the first feature point may be related to a point where a real part value of the impedance is the smallest among the plurality of points identified based on the EIS graph, and the second feature point may be related to the inflection point or a point having a frequency lower than a frequency corresponding to the inflection point among the plurality of points identified based on the EIS graph.

According to one embodiment, the angle parameter may be related to an angle between a straight line connecting the second feature point to the first feature point and one coordinate axis of the EIS graph.

According to one embodiment, the relationship data may be generated based on first EIS data acquired from a reference battery pack at a first temperature under a specified state of charge (SOC) condition and a specified SOH condition in an idle section of the reference battery pack, and second EIS data acquired from a reference battery pack at a reference SOH under a specified SOC condition and a specified temperature condition in the idle section of the reference battery pack.

According to one embodiment, the predicting of the SOH may include generating a function representing a tendency between a plurality of temperatures included in the first temperature and an angle parameter corresponding to each of the plurality of temperatures based on the first EIS data, acquiring a plurality of temperatures included in the first temperature and an angle parameter corresponding to each of a plurality of SOHs included in the reference SOH based on the first EIS data and the second EIS data, and generating a function representing a tendency between the angle parameter and the plurality of SOHs at the first temperature.

### Advantageous Effects

The SOH prediction device according to one embodiment disclosed herein can predict the SOH according to the angle parameter without collecting the angle parameter corresponding to each of all SOHs.

The SOH prediction device according to one embodiment disclosed herein can approximate the angle parameter to acquire the approximated angle parameter through the pattern and coordinates of the EIS data.

The effects according to one embodiment disclosed herein are not limited to the above-described effects and other effects that are not described will be able to be clearly understood by those skilled in the art according to the disclosure of the present document.

### Description of Drawings

FIG. 1 is a view for describing a state of health (SOH) prediction device according to one embodiment disclosed herein.
FIGS. 2 to 5 are views for describing EIS data and a plurality of feature points acquired based on the EIS data according to one embodiment disclosed herein.
FIG. 6 is a view for describing relationship data according to one embodiment disclosed herein.
FIG. 7 is a view for describing the relationship between an angle parameter and a temperature and the angle parameter and the temperature according to one embodiment disclosed herein.
FIG. 8 is a flowchart for describing an operation of the SOH prediction device according to one embodiment disclosed herein.
FIG. 9 is a flowchart for describing an operation of the SOH prediction device according to one embodiment disclosed herein.

### Mode for Invention

Hereinafter, embodiments disclosed herein will be described in detail with reference to exemplary drawings. In adding reference numerals to components in each drawing, it should be noted that the same components have the same reference numerals as much as possible even when they are shown in different drawings. In addition, in describing embodiments disclosed herein, the detailed description of related known configurations or functions will be omitted when it is determined that the detailed description obscures the understanding of the embodiments disclosed herein.

The terms, such as first, second, A, B, (a), and (b) may be used to describe components of the embodiments disclosed in this document. These terms are only for the purpose of distinguishing one component from another component, and the nature, sequence, order, or the like of the corresponding component is not limited by the terms. In addition, unless otherwise defined, all terms (including technical and scientific terms) used herein have the same meanings as those commonly understood by those skilled in the art to which embodiments disclosed herein pertains. The terms defined in a generally used dictionary should be construed as meanings that match with the meanings of the terms from the context of the related technology and are not construed as an ideal or excessively formal meaning unless clearly defined in this application.

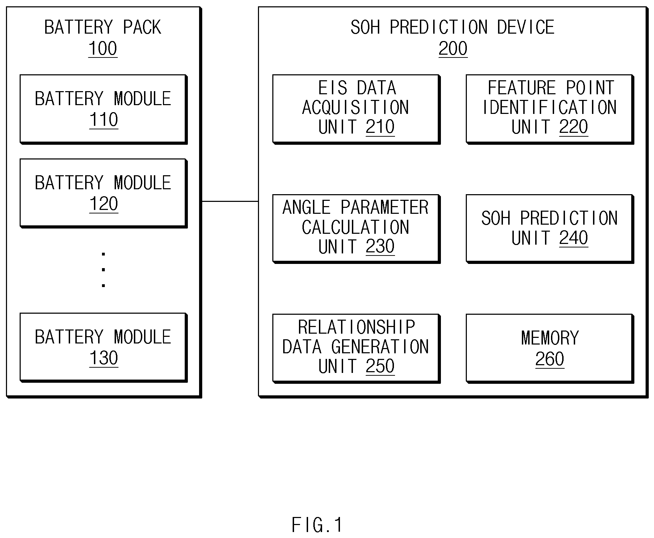

FIG. 1 is a view for describing a state of health (SOH) prediction device according to one embodiment disclosed herein.

A battery pack 100 may include a plurality of battery modules 110, 120, and 130. Referring to FIG. 1, it is shown that the battery pack 100 includes three battery modules 110, 120, and 130, but is not limited thereto, and the battery pack 100 may include n (n is a natural number) battery modules. Each of the plurality of battery modules 110, 120, and 130 may include a plurality of battery cells (not shown). The plurality of battery cells (not shown) may be lithium ion (Li-ion) batteries, nickel hydrogen (Ni-H) batteries, etc., but are not limited thereto.

The battery pack 100 may be configured to supply power to a target device (not shown), and to this end, the battery pack 100 may be electrically connected to the target device (not shown). Here, the target device (not shown) may include an electrical, electronic, or mechanical device operated by receiving power from the battery pack 100, and for example, the target device (not shown) may be a two-wheeled electric vehicle such as an electric vehicle (EV) or an electric scooter, but is not limited thereto. In addition, when the target device is a two-wheeled electric vehicle such as an electric scooter, the battery pack 100 mounted on the two-wheeled electric vehicle may be replaced through a battery swapping station (BSS).

A SOH prediction device 200 may predict a SOH of the battery pack 100 based on an angle parameter related to the impedance of the battery pack 100. Referring to FIG. 1, the SOH prediction device 200 may include an electrochemical impedance spectroscopy (EIS) data acquisition unit 210, a feature point identification unit 220, an angle parameter calculation unit 230, an SOH prediction unit 240, a relationship data generation unit 250, and a memory 260.

The EIS data acquisition unit 210 may acquire EIS data acquired as a result of the EIS measurement of the battery pack 100. According to an embodiment, the EIS measurement may include an operation of measuring the impedance of the battery pack 100 by applying an AC voltage to the battery pack 100.

According to an embodiment, the EIS data may include data on an EIS graph. For example, the EIS graph may be a Nyquist plot shown by dividing the impedance of the battery pack 100 measured by changing a frequency of the AC voltage into a real part and an imaginary part.

According to one embodiment, the EIS data acquisition unit 210 may acquire EIS data by directly applying a voltage and/or current to the battery pack 100. In this case, the EIS data acquisition unit 210 may include various circuits for applying a voltage and/or current to the battery pack 100 and a processor for processing the acquired EIS data.

According to one embodiment, the EIS data acquisition unit 210 may indirectly acquire the EIS data from the battery pack 100. In this case, the EIS data acquisition unit 210 may include a communication module for communicating with the battery pack 100 in a wired and/or wireless manner.

The feature point identification unit 220 may identify a plurality of feature points based on the acquired EIS data. According to one embodiment, the feature point identification unit 220 may identify at least two feature points among the plurality of feature points identified based on the EIS graph included in the EIS data.

According to an embodiment, a first feature point and a second feature point among the plurality of feature points may be related to a pattern of the EIS graph in a reference frequency region, which is a frequency region higher than a frequency corresponding to a maximum point among the plurality of points identified based on the EIS graph.

The angle parameter calculation unit 230 may calculate an angle parameter related to the impedance of the first feature point and the second feature point among the plurality of feature points. According to an embodiment, the angle parameter may be defined as an angle between a straight line connecting the first feature point to the second feature point and a coordinate axis of the EIS graph. For example, based on an x-axis corresponding to the coordinate axis representing the real part of the coordinate axis of the EIS graph, the angle parameter may include data related to an angle between the straight line connecting the first feature point to the second feature point and the x-axis, and based on a y-axis corresponding to the coordinate axis representing the imaginary part of the coordinate axis of the EIS graph, the angle parameter may include data related to an angle between the straight line connecting the first feature point to the second feature point and the y-axis.

The SOH prediction unit 240 may predict an SOH of the battery pack 100 based on the angle parameter calculated by the angle parameter calculation unit 230. According to an embodiment, the SOH prediction unit 240 may predict the SOH of the battery pack 100 based on a temperature at which the EIS data was acquired and relationship data between an angle parameter corresponding to the temperature at which the EIS data was acquired and the SOH.

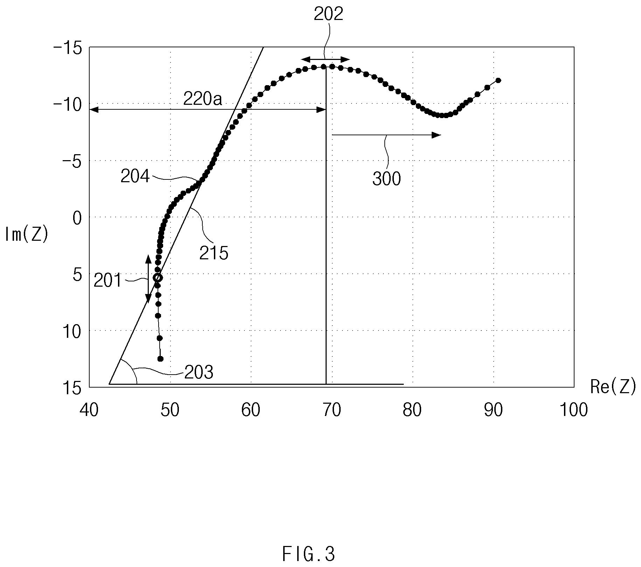

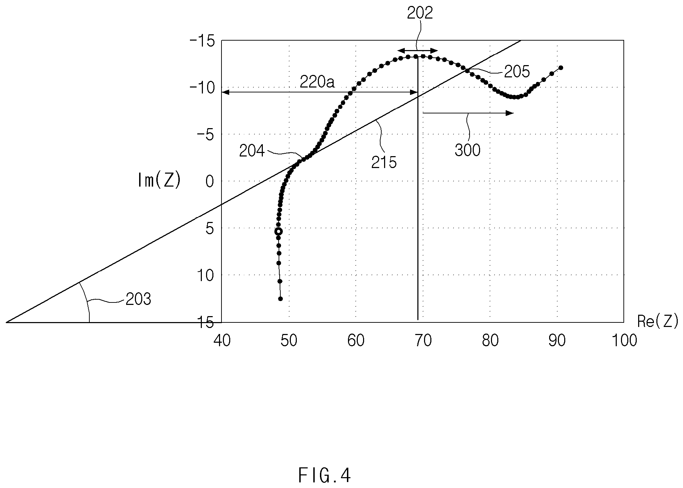

The relationship data generation unit 250 may generate relationship data. A process of generating the relationship data will be described in detail in the description of FIGS. 3 and 4.

The memory 260 may store the relationship data generated by the relationship data generation unit 250. According to an embodiment, the memory 260 may include a volatile memory device such as a static random access memory (SRAM) or a dynamic random access memory (DRAM), or a non-volatile memory device such as a read only memory (ROM), a programmable ROM (PROM), or a flash memory.

Referring to FIG. 1, it is shown that the memory 260 is included in the SOH prediction device 200, but is not limited thereto, and the memory 260 may be located outside the SOH prediction device 200.

According to an embodiment, the feature point identification unit 220, the angle parameter calculation unit 230, the SOH prediction unit 240, and the relationship data generation unit 250 may be implemented as one processor or separate processors. Here, the processor may execute software to control one or more other components (e.g., hardware or software) of the SOH prediction device 200 or perform operations of processing and/or calculating various pieces of data.

According to an embodiment, the SOH prediction device 200 may be formed integrally with the battery pack 100. In this case, the SOH prediction device 200 may be included in a battery management system (BMS) of the battery pack 100.

According to an embodiment, the SOH prediction device 200 may be formed separately from the battery pack 100. In this case, the SOH prediction device 200 may be connected to the battery pack 100 via a wired and/or wireless network. In this case, the SOH prediction device 200 may be implemented through a cloud server.

According to an embodiment, the SOH prediction device 200 may transmit the relationship data generated by the relationship data generation unit 250 and/or the SOH of the battery pack 100 predicted by the SOH prediction unit 240 to an external device (e.g., a cloud server or a user terminal). The cloud server may be configured to provide the predicted SOH of the battery pack 100 to each of a plurality of users, and the user terminal may include a terminal such as a personal computer (PC) or a smartphone.

According to an embodiment, the SOH prediction device 200 may be included in a BSS. The BSS may be a system that may have a slot into which the battery pack 100 may be inserted and charge the inserted battery pack 100.

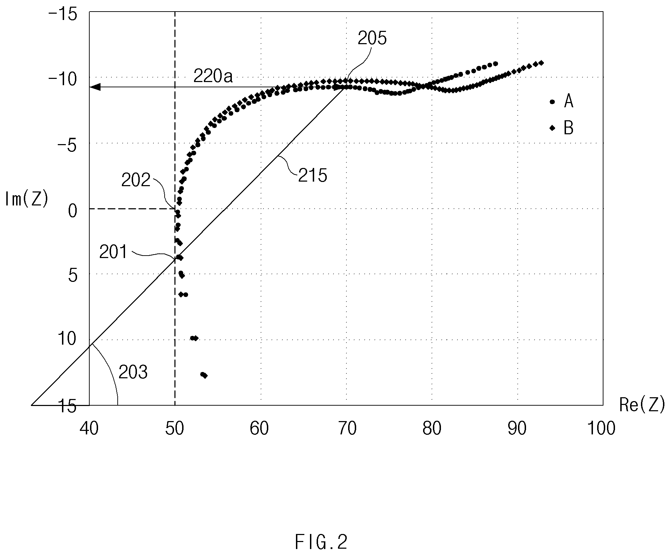

FIGS. 2 to 5 are views for describing EIS data and a plurality of feature points acquired based on the EIS data according to one embodiment disclosed herein.

First, referring to FIG. 2, an EIS graph included in the EIS data according to one embodiment disclosed herein is schematically shown.

As described above in the detailed description of FIG. 1, the EIS data may include data on the EIS graph shown by dividing the impedance of the battery pack 100, which is measured by changing the frequency of the AC power applied to the battery pack 100 (see FIG. 1), into a real part Re(Z) and an imaginary part Im(Z). According to an embodiment, a horizontal axis of the EIS graph may be a coordinate axis corresponding to the real part Re(Z), and a vertical axis may be a coordinate axis corresponding to the imaginary part Im(Z). In addition, as described above in the description of FIG. 1, the first feature point and the second feature point among a plurality of feature points may be related to the pattern of the EIS graph in the reference frequency region, which is a frequency region higher than the frequency corresponding to the maximum point among the plurality of points identified based on the EIS graph.

According to an embodiment, the first feature point and the second feature point may be related to the maximum point 205 and the pattern of the EIS graph in a reference frequency region 220a, which is a region corresponding to a higher frequency than the maximum point 205. For example, the first feature point and the second feature point may vary depending on each of a case in which there is no inflection point among the plurality of points identified based on the pattern of the EIS graph in the reference frequency region 220a as shown in FIG. 2 and a case in which there is the inflection point 205 among the plurality of points identified based on the pattern of the EIS graph in the reference frequency region 220a as shown in FIGS. 3 to 5.

Referring back to FIG. 2, an embodiment in which there is no inflection point in the reference frequency region 220a is shown. The feature point identification unit 220 (see FIG. 1) may identify the first feature point 210 and the second feature point 220 among the plurality of feature points identified based on the EIS graph.

According to an embodiment, the first feature point 210 may be related to a point where the real part value of the impedance of the battery pack 100 is the smallest or a point where the above real part value is the smallest in the EIS graph. For example, the first feature point 210 may correspond to a point where the real part value of the impedance is the smallest or a point that is located within a preset range from the point where the real part value is the smallest in the EIS graph. In addition, the second feature point 220 may be a point where the imaginary part value of the impedance is zero or one of points having a frequency lower than a frequency corresponding to the point where the imaginary part value is zero in the EIS graph.

According to one embodiment, the first feature point may be related to the point where the imaginary part value of the impedance of the battery pack 100 is zero in the EIS graph. For example, the first feature point may correspond to the point where the imaginary part value of the impedance is zero or the point that is located within a preset range from the point where the imaginary part value is zero in the EIS graph. In addition, the second feature point may be related to a point corresponding to a frequency lower than a frequency corresponding to the first feature point. That is, the second feature point may be the point where the imaginary part value of the impedance is zero or one of points having a frequency lower than a frequency corresponding to the point that is located within the preset range from the point where the imaginary part value is zero. Here, the preset range may be set and changed in various ways.

For convenience of description, the following description will be made assuming that the first feature point 210 is a point where the real part value of the impedance of the battery pack 100 is the smallest and the second feature point 205 is the maximum point 205 among the points having a lower frequency than the point where the imaginary part value of the impedance is zero, but the present document is not limited to this embodiment.

The angle parameter calculation unit 230 may calculate an angle parameter 230 based on the first feature point 210 and the second feature point 205. According to an embodiment, the angle parameter may be defined as the angle between a straight line 215 connecting the first feature point 210 to the second feature point 205 and the coordinate axis of the EIS graph. For convenience of description, the following description will be made assuming that a reference for calculating the angle parameter 230 is a horizontal axis, but the present document is not limited thereto.

For example, based on the horizontal axis corresponding to the coordinate axis Re(Z) representing the real part among the coordinate axes of the EIS graph, the angle parameter 230 may include data on an angle between the straight line 215 connecting the first feature point 210 to the second feature point 205 and the horizontal axis.

For another example, based on the vertical axis corresponding to the coordinate axis Im(Z) representing the real part among the coordinate axes of the EIS graph, the angle parameter may include data on an angle between the straight line 215 connecting the first feature point 210 to the second feature point 205 and the vertical axis.

According to an embodiment, the angle parameter calculation unit 230 may calculate the angle parameter through a calculation process using the magnitude of the impedance calculated based on a difference in impedance of the first feature point 210 and the second feature point 205, various trigonometric functions, etc., but is not limited to this example.

Referring to FIGS. 3 to 5, an EIS graph included in the EIS data according to one embodiment disclosed herein is schematically shown.

As described above in the description of FIG. 1, the first feature point and the second feature point among the plurality of feature points may be related to the pattern of the EIS graph in the reference frequency region 220a, which is a frequency region higher than the frequency corresponding to the maximum point 220 among the plurality of points identified based on the EIS graph. Here, the EIS graphs shown in FIGS. 3 to 5 may each include various embodiments in which an inflection point is present in the reference frequency range 220a. First, referring to FIG. 3, an inflection point 240 is present in the reference frequency range 220a. Here, the inflection point may correspond to a point where the pattern of the EIS graph changes.

According to one embodiment, when the inflection point 240 is present in the reference frequency range 220a, the first feature point 210 may be related to the point where the real part value of the impedance is the smallest among the plurality of points identified based on the EIS graph. For example, the first feature point 210 may correspond to the point where the real part value of the impedance is the smallest or one of the points that are located within the preset range from the point where the real part value is the smallest. Here, the preset range may be changed and applied in various ways and for example, may be determined together with a point that is located at a frequency in a certain range, within a certain range on a graph, etc., based on an allowable error, etc. in the process of analyzing the EIS graph, but is not limited to this example.

According to one embodiment, when the inflection point 240 is present in the reference frequency range 220a, the second feature point 240 may be related to the inflection point 240. For example, the second feature point 240 may correspond to the inflection point 240 or one of points having a frequency lower than a frequency corresponding to the inflection point 240. For convenience of description, the following description will be made assuming that the first feature point 210 corresponds to the point where the real part value of the impedance is the smallest and the second feature point 240 corresponds to the inflection point, but the present document is not limited to this example.

The angle parameter calculation unit 230 (see FIG. 1) may calculate the angle parameter 230 based on the first feature point 210 and the second feature point 240. According to an embodiment, the angle parameter may be defined as the angle between the straight line 215 connecting the first feature point 210 to the second feature point 240 and the coordinate axis of the EIS graph. For convenience of description, the following description will be made assuming that a reference for calculating the angle parameter 230 is a horizontal axis, but the present document is not limited thereto.

For example, based on the horizontal axis corresponding to the coordinate axis Re(Z) representing the real part among the coordinate axes of the EIS graph, the angle parameter 230 may include data on an angle between the straight line 215 connecting the first feature point 210 to the second feature point 240 and the horizontal axis.

For another example, based on the vertical axis corresponding to the coordinate axis Im(Z) representing the real part among the coordinate axes of the EIS graph, the angle parameter may include data on an angle between the straight line 215 connecting the first feature point 210 to the second feature point 240 and the vertical axis.

According to an embodiment, the angle parameter calculation unit 230 may calculate the angle parameter through a calculation process using the magnitude of the impedance calculated based on a difference in impedance of the first feature point 210 and the second feature point 240, various trigonometric functions, etc., but is not limited to this example.

Referring to FIG. 4, as shown in FIG. 3, the inflection point 240 is present in the reference frequency range 220a. Here, the inflection point 240 may correspond to a point where the pattern of the EIS graph changes.

According to one embodiment, when the inflection point 240 is present in the reference frequency range 220a, the first feature point 240 may be related to the inflection point 240 among a plurality of points identified based on the EIS graph. For example, the first feature point 240 may correspond to the inflection point 240 where the pattern of the EIS graph changes and one of points that are located within a preset range from the inflection point 240. Here, the inflection point 240 may correspond to the inflection point 240 where the pattern of the EIS graph changes among the points corresponding to a higher frequency than the maximum point 220 among the plurality of inflection points identified on the EIS graph. In addition, the preset range may be set and applied in various ways.

According to one embodiment, when the inflection point 240 is present in the reference frequency range 220a, the second feature point 250 may be related to the inflection point 240. For example, the second feature point 250 may correspond to one of points having a frequency lower than a frequency corresponding to the inflection point 240. That is, the second feature point 250 may correspond to one of the points having a lower frequency than the first feature point 240. For convenience of description, the following description will be made assuming that the first feature point 240 corresponds to the inflection point and the second feature point 240 corresponds to any point having a lower frequency than the inflection point, but the present document is not limited to this example.

The angle parameter calculation unit 230 (see FIG. 1) may calculate the angle parameter 230 based on the first feature point 240 and the second feature point 250. According to an embodiment, the angle parameter may be defined as the angle between the straight line 215 connecting the first feature point 240 to the second feature point 250 and the coordinate axis of the EIS graph. For convenience of description, the following description will be made assuming that a reference for calculating the angle parameter 230 is a horizontal axis, but the present document is not limited thereto.

For example, based on the horizontal axis corresponding to the coordinate axis Re(Z) representing the real part among the coordinate axes of the EIS graph, the angle parameter 230 may include data on an angle between the straight line 215 connecting the first feature point 240 to the second feature point 250 and the horizontal axis.

For another example, based on the vertical axis corresponding to the coordinate axis Im(Z) representing the real part among the coordinate axes of the EIS graph, the angle parameter may include data on an angle between the straight line 215 connecting the first feature point 240 to the second feature point 250 and the vertical axis.

According to an embodiment, the angle parameter calculation unit 230 may calculate the angle parameter through a calculation process using the magnitude of the impedance calculated based on a difference in impedance of the first feature point 240 and the second feature point 250, various trigonometric functions, etc., but is not limited to this example.

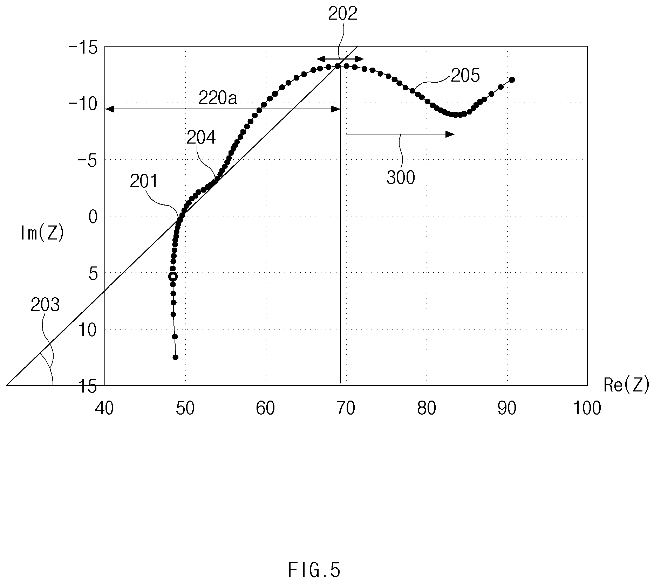

Referring to FIG. 5, as shown in FIG. 3, the inflection point 240 is present in the reference frequency range 220a. Here, the inflection point 240 may correspond to a point where the pattern of the EIS graph changes.

According to one embodiment, when the inflection point 240 is present in the reference frequency range 220a, the first feature point 210 may be related to the point where the imaginary part value of the impedance is zero among the plurality of points identified based on the EIS graph. For example, the first feature point 210 may correspond to the point 210 where the imaginary part value of the impedance is zero or one of points that are located within a preset range from the point where the imaginary part value of the impedance is zero among the plurality of points identified based on the graph. Here, the preset range may be set and applied in various ways.

According to one embodiment, when the inflection point 240 is present in the reference frequency range 220a, the second feature point 240 may be related to the inflection point. For example, the second feature point 240 may correspond to the inflection point 240 or one of points having a frequency lower than a frequency corresponding to the inflection point 240. For convenience of description, the following description will be made assuming that the first feature point 210 corresponds to the point where the imaginary part value of the impedance is zero and the second feature point 240 corresponds to the inflection point among the plurality of points identified based on the EIS graph, but the present document is not limited to this example.

The angle parameter calculation unit 230 (see FIG. 1) may calculate the angle parameter 230 based on the first feature point 210 and the second feature point 240. According to an embodiment, the angle parameter may be defined as the angle between the straight line 215 connecting the first feature point 210 to the second feature point 240 and the coordinate axis of the EIS graph. For convenience of description, the following description will be made assuming that a reference for calculating the angle parameter 230 is a horizontal axis, but the present document is not limited thereto.

For example, based on the horizontal axis corresponding to the coordinate axis Re(Z) representing the real part among the coordinate axes of the EIS graph, the angle parameter 230 may include data on an angle between the straight line 215 connecting the first feature point 210 to the second feature point 240 and the horizontal axis.

For another example, based on the vertical axis corresponding to the coordinate axis Im(Z) representing the real part among the coordinate axes of the EIS graph, the angle parameter may include data on an angle between the straight line 215 connecting the first feature point 210 to the second feature point 240 and the vertical axis.

According to an embodiment, the angle parameter calculation unit 230 may calculate the angle parameter through a calculation process using the magnitude of the impedance calculated based on a difference in impedance of the first feature point 210 and the second feature point 240, various trigonometric functions, etc., but is not limited to this example.

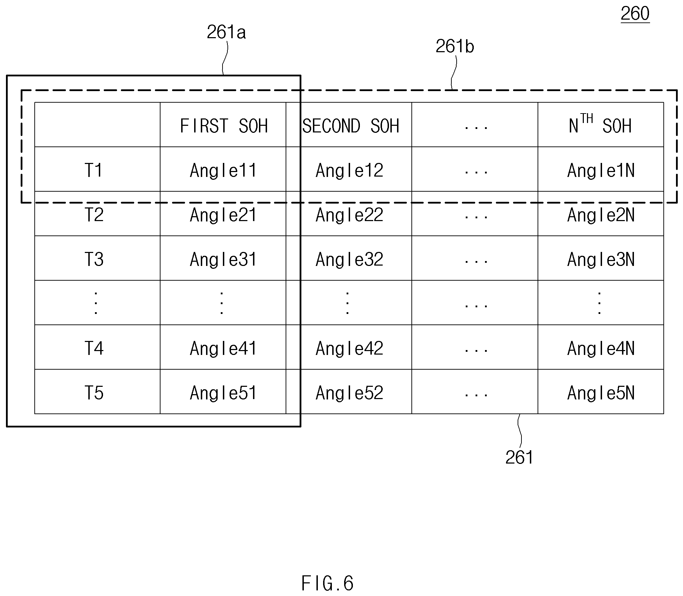

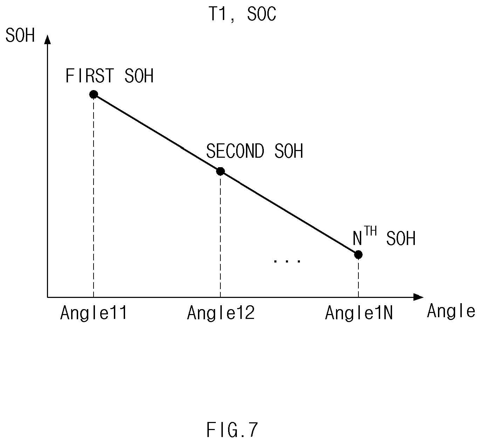

FIG. 6 is a view for describing relationship data according to one embodiment disclosed herein, and FIG. 7 is a view for describing the relationship between an angle parameter and a temperature and the angle parameter and the temperature according to one embodiment disclosed herein.

The relationship data generation unit 250 may generate relationship data 261 as shown in FIG. 6. The relationship data generation unit 250 may generate the relationship data 261 based on EIS data of a reference battery pack. Here, the reference battery pack may be the same type of a battery pack as the battery pack 100 (see FIG. 1). According to an embodiment, the relationship data 261 may include data indicating a corresponding relationship between a temperature, an SOH, and an angle parameter, and the relationship data 261 may be stored in the memory 260 in the form of a look-up table as shown in FIG. 6.

According to an embodiment, the relationship data generation unit 250 may generate relationship data 261a between first temperatures T1 to T5 and angle parameters Angle11 to Angle 51 corresponding to each of the first temperatures based on first EIS data corresponding to each of the first temperatures T1 to T5 under a preset first condition. Here, the preset first condition may include a specified state of charge (SOC) condition and a specified SOH condition in a reference battery pack in an idle state.

For example, the relationship data generation unit 250 may generate the relationship data 261a by changing the temperature of the reference battery pack corresponding to a first SOH condition to the first temperatures T1 to T5 under the specified SOC condition. In addition, the relationship data generation unit 250 may generate relationship data by changing a temperature of the reference battery pack corresponding to a second SOH condition to the first temperatures T1 to T5 under the specified SOC condition.

According to an embodiment, there may be a tendency between the temperature and the angle parameter. Referring to FIG. 4, a graph between the angle parameters Angle11 to Angle51 corresponding to each of the first temperatures T1 to T5 is shown. The relationship data generation unit 250 may generate a function representing a tendency between the temperature and the angle parameter based on the first temperatures T1 to T5 and the angle parameters Angle11 to Angle51 corresponding to each of the first temperatures T1 to T5.

According to an embodiment, the relationship data generation unit 250 may calculate an angle parameter corresponding to each temperature based on the function representing the tendency between the temperature and the angle parameter. The relationship data generation unit 250 may supplement relationship data 261 based on the angle parameter calculated by substituting different temperatures into the function representing the tendency between the temperature and the angle parameter.

Referring back to FIG. 3, the relationship data generation unit 250 may generate relationship data 261b between reference SOHs first SOH to N^{th} SOH and angle parameters Angle11 to Angle 1N corresponding to the reference SOHs, respectively, based on second EIS data corresponding to each of the reference SOHs first SOH to N^{th} SOH under a preset second condition. Here, the preset second condition may include a specified SOC condition and a specified temperature condition in a reference battery pack in an idle state.

For example, the relationship data generation unit 250 may generate the relationship data 261b based on the angle parameters Angle 11 to Angle 1N acquired by changing the SOH of the reference battery pack corresponding to a specified temperature condition T1 to the reference SOHs first SOH to N^{th} SOH under the specified SOC condition. In addition, the relationship data generation unit 250 may generate relationship data based on angle parameters Angle 21 to Angle 2N acquired by changing the SOH of the reference battery pack corresponding to a specified temperature condition T2 to the reference SOHs first SOH to N^{th} SOH under the specified SOC condition.

According to an embodiment, there may be a tendency between the SOH and the angle parameter. Referring back to FIG. 7, a graph between the reference SOHs first SOH to N^{th} SOH corresponding to the angle parameters Angle 11 to Angel 1N, respectively is shown. The relationship data generation unit 250 may generate a function representing the tendency between the angle parameters and the SOH of the reference battery pack based on the angle parameters Angle 11 to Angel 1N and the reference SOHs first SOH to N^{th} SOH corresponding to the angle parameters Angle 11 to Angel 1N, respectively.

According to an embodiment, the function representing the tendency between the angle parameter and the SOH may include a polynomial function. For example, the function representing the tendency between the angle parameter and the SOH may be represented in the form of a linear function representing the linear relationship between the angle parameter and the SOH, but is not limited thereto.

According to an embodiment, the relationship data generation unit 250 may calculate the SOH corresponding to each angle parameter based on the function representing the tendency between the angle parameter and the SOH. The relationship data generation unit 250 may supplement the relationship data 261 based on the SOH calculated by substituting different angle parameters into the function representing the tendency between the angle parameter and the SOH.

To predict the lifetime of the battery pack through EIS analysis, EIS data needs to be repeatedly collected by changing various conditions (e.g., a temperature, a SOC, and a SOH). However, the process of repeatedly collecting the EIS data as described above may be time-consuming. In addition, a process of measuring the impedance of a battery pack through EIS analysis tends to take more time in a low-frequency region than in a high-frequency region.

The SOH prediction device according to an embodiment disclosed herein may predict the SOH of the battery pack based on the function acquired by changing conditions in which a tendency is present without having to collect EIS data under various conditions (e.g., all temperatures or all SOHs). In addition, since the SOH prediction device according to one embodiment disclosed herein may predict the SOH based on the angle parameter between the first feature point and the second feature point, the SOH of the battery pack may be predicted without measuring the impedance of the battery pack at a lower frequency than the second feature point.

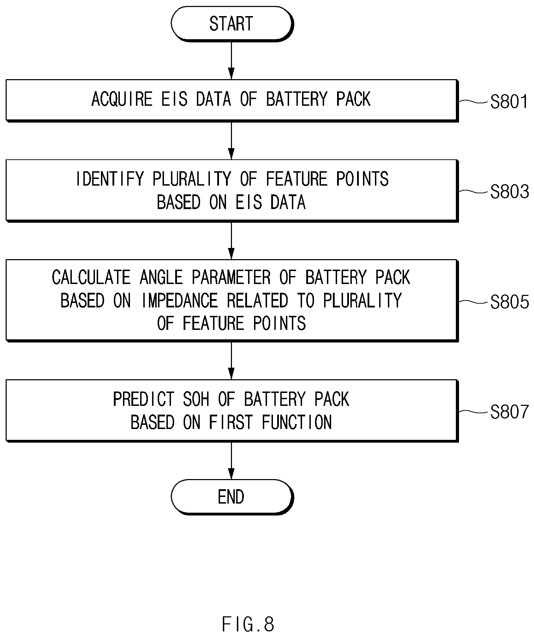

FIG. 8 is a flowchart for describing an operation of the SOH prediction device according to one embodiment disclosed herein.

In operation S801, the SOH prediction device 200 (see FIG. 1) may acquire the EIS data of the battery pack 100 (see FIG. 1). According to an embodiment, the EIS data may include data on an EIS graph shown by dividing the impedance of the battery pack 100 into a real part and an imaginary part.

In operation S803, the SOH prediction device 200 may identify a plurality of feature points based on the EIS data. According to an embodiment, a first feature point among the plurality of feature points may correspond to a point where the real part value of the impedance of the battery pack 100 is the smallest or a point where the imaginary part value of the impedance of the battery pack 100 is zero in the EIS graph. In addition, a second feature point among the plurality of feature points may be a maximum point and/or one of points having a frequency lower than a frequency corresponding to the maximum point in the EIS graph.

In operation S805, the SOH prediction device 200 may calculate an angle parameter of the battery pack 100 based on the impedance related to the plurality of feature points. According to an embodiment, the angle parameter may include data on an angle between a straight line connecting the second feature point to the first feature point and one coordinate axis of the EIS graph.

In operation S807, the SOH prediction device 200 may predict an SOH of the battery pack 100 based on a temperature at which the EIS data was acquired, the calculated angle parameter, and the relationship data between the angle parameter and the SOH of the battery pack 100.

According to an embodiment, the relationship data may be generated based on first EIS data acquired from a reference battery pack at a first temperature under a specified SOC condition and a specified SOH condition in an idle section of the reference battery pack, and second EIS data acquired from a reference battery pack at a first SOH under a specified SOC condition and a specified temperature condition in the idle section of the reference battery pack. Here, the reference battery pack may be the same type of battery pack as the battery pack 100.

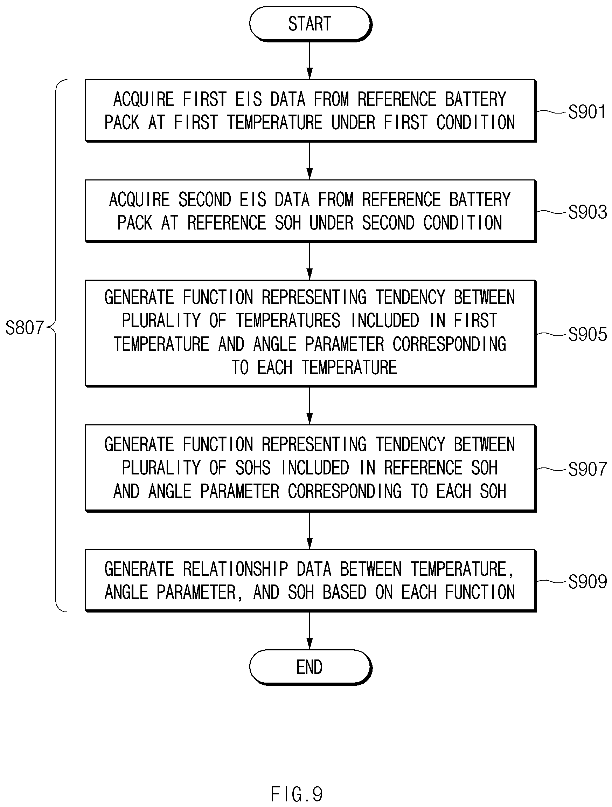

FIG. 9 is a flowchart for describing an operation of the SOH prediction device according to one embodiment disclosed herein.

Referring to FIG. 9, operation S807 shown in FIG. 8 will be specifically described.

In operation S901, the SOH prediction device 200 (see FIG. 1) may acquire the first EIS data from the reference battery pack at the first temperature under a first condition, and in operation S903, the SOH prediction device 200 may acquire the second EIS data from the reference battery pack at a reference SOH under a second condition.

According to an embodiment, the first condition may include the specified SOC condition and the specified SOH condition in the idle section of the reference battery pack, and the second condition may include the specified SOC condition and the specified temperature condition in the idle section of the reference battery pack.

In operation S905, the SOH prediction device 200 may generate a function representing a tendency between a plurality of temperatures included in the first temperature and an angle parameter corresponding to each of the plurality of temperatures. In addition, in operation S907, the SOH prediction device 200 may generate a function representing a tendency between a plurality of SOHs included in the reference SOH and an angle parameter corresponding to each of the plurality of SOHs.

In operation S909, the SOH prediction device 200 may generate relationship data between a temperature, an angle parameter, and an SOH based on each function generated in operations S905 and S907.

All components constituting the embodiments have been described above as being coupled as one or operated by being coupled, but are not necessarily limited to these embodiments, and within the scope of the purpose, one or more of all components may be operated by being selectively coupled. In addition, the terms such as "comprise," "constitute," or "have" described above mean that the corresponding component may be inherent unless otherwise stated, and thus should be construed as further including another component rather than excluding another component.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

### [DESCRIPTION OF REFERENCE NUMERALS]

100: battery pack
110, 120, 130: battery module
200: SOH prediction device
210: EIS data acquisition unit
220: feature point identification unit
230: angle parameter calculation unit
240: SOH prediction unit
250: relationship data generation unit
260: memory

## Claims

1. A state of health (SOH) prediction device comprising:
a battery pack;
an electrochemical impedance spectroscopy (EIS) data acquisition unit configured to acquire EIS data of the battery pack;
a feature point identification unit configured to identify a plurality of feature points based on the EIS data;
an angle parameter calculation unit configured to calculate an angle parameter related to impedance of the battery pack based on impedance related to the plurality of feature points; and
an SOH prediction unit configured to predict an SOH corresponding to the calculated angle parameter based on relationship data between a temperature at which the EIS data was acquired, the angle parameter, and an SOH of the battery pack.

2. The SOH prediction device of claim 1, wherein the EIS data includes data on an EIS graph shown by dividing the impedance of the battery pack into a real part and an imaginary part, and
a first feature point and a second feature point among the plurality of feature points are related to whether there is an inflection point in the EIS graph in a reference frequency region higher than a frequency corresponding to a maximum point among a plurality of points identified based on the EIS graph.

3. The SOH prediction device of claim 2, wherein, when the inflection point is not present in the reference frequency region,
the first feature point is related to a point where a real part value of the impedance is the smallest among the plurality of points identified based on the EIS graph, and
the second feature point is related to a point where an imaginary part value of the impedance is zero or a point having a frequency lower than a frequency corresponding to the point where the imaginary part value is zero among the plurality of points identified based on the EIS graph.

4. The SOH prediction device of claim 2, wherein, when the inflection point is not present in the reference frequency region,
the first feature point is related to a point where an imaginary part value of the impedance is zero among the plurality of points identified based on the EIS graph, and
the second feature point is related to a point having a frequency lower than a frequency corresponding to the first feature point among the plurality of points identified based on the EIS graph.

5. The SOH prediction device of claim 2, wherein, when the inflection point is present in the reference frequency region,
the first feature point is related to a point where a real part value of the impedance is the smallest among the plurality of points identified based on the EIS graph, and
the second feature point is related to the inflection point or a point having a frequency lower than a frequency corresponding to the inflection point among the plurality of points identified based on the EIS graph.

6. The SOH prediction device of claim 2, wherein, when the inflection point is present in the reference frequency region,
the first feature point is related to the inflection point, and
the second feature point is related to points corresponding to a frequency lower than a frequency corresponding to the inflection point.

7. The SOH prediction device of claim 2, wherein, when the inflection point is present in the reference frequency region,
the first feature point is related to a point where an imaginary part value of the impedance is zero among the plurality of points identified based on the EIS graph, and
the second feature point is related to the inflection point or points corresponding to a frequency lower than a frequency corresponding to the inflection point.

8. The SOH prediction device of claim 2, wherein the angle parameter is related to an angle between a straight line connecting the second feature point to the first feature point and one coordinate axis of the EIS graph.

9. The SOH prediction device of claim 2, wherein the EIS data includes data on an EIS graph shown at a frequency corresponding to the second feature point and in a frequency region higher than a frequency corresponding to the second feature point.

10. The SOH prediction device of claim 1, further comprising:
a relationship data generation unit configured to generate the relationship data; and
a memory configured to store the relationship data,
wherein the relationship data is generated based on first EIS data acquired from a reference battery pack at a first temperature under a preset first condition and second EIS data acquired from the reference battery pack at a reference SOH under a preset second condition.

11. The SOH prediction device of claim 10, wherein the preset first condition includes a specified state of charge (SOC) condition and a specified SOH condition in an idle section of the reference battery pack, and
the preset second condition includes a specified SOC condition and a specified temperature condition in the idle section of the reference battery pack.

12. The SOH prediction device of claim 11, wherein the relationship data generation unit generates a function representing a tendency between a plurality of temperatures included in the first temperature and an angle parameter corresponding to each of the plurality of temperatures based on the first EIS data.

13. The SOH prediction device of claim 11, wherein the relationship data generation unit acquires a plurality of temperatures included in the first temperature and an angle parameter corresponding to each of a plurality of SOHs included in the reference SOH based on the first EIS data and the second EIS data and generates a function representing a tendency between the angle parameter and the plurality of SOHs at the first temperature.

14. A method of operating a state of health (SOH) prediction device, the method comprising:
acquiring electrochemical impedance spectroscopy (EIS) data of a battery pack;
identifying a plurality of feature points based on the EIS data;
calculating an angle parameter related to impedance of the battery pack based on impedance related to the plurality of feature points; and
predicting an SOH corresponding to the calculated angle parameter based on relationship data between a temperature at which the EIS data was acquired, the angle parameter, and an SOH of the battery pack.

15. The method of claim 14, wherein the EIS data includes data on an EIS graph shown by dividing the impedance of the battery pack into a real part and an imaginary part, and
a first feature point and a second feature point among the plurality of feature points are related to whether there is an inflection point in the EIS graph in a reference frequency region higher than a frequency corresponding to a maximum point among a plurality of points identified based on the EIS graph.

16. The method of claim 15, wherein, when the inflection point is not present in the reference frequency region,
the first feature point is related to a point where a real part value of the impedance is the smallest among the plurality of points identified based on the EIS graph, and
the second feature point is related to a point where an imaginary part value of the impedance is zero or a point having a frequency lower than a frequency corresponding to the point where the imaginary part value is zero among the plurality of points identified based on the EIS graph, and
when the inflection point is present in the reference frequency region,
the first feature point is related to a point where a real part value of the impedance is the smallest among the plurality of points identified based on the EIS graph, and
the second feature point is related to the inflection point or a point having a frequency lower than a frequency corresponding to the inflection point among the plurality of points identified based on the EIS graph.

17. The method of claim 15, wherein the angle parameter is related to an angle between a straight line connecting the second feature point to the first feature point and one coordinate axis of the EIS graph.

18. The method of claim 14, wherein the relationship data is generated based on first EIS data acquired from a reference battery pack at a first temperature under a specified state of charge (SOC) condition and a specified SOH condition in an idle section of the reference battery pack, and second EIS data acquired from a reference battery pack at a reference SOH under a specified SOC condition and a specified temperature condition in the idle section of the reference battery pack.

19. The method of claim 18, wherein the predicting of the SOH includes:
generating a function representing a tendency between a plurality of temperatures included in the first temperature and an angle parameter corresponding to each of the plurality of temperatures based on the first EIS data;
acquiring a plurality of temperatures included in the first temperature and an angle parameter corresponding to each of a plurality of SOHs included in the reference SOH based on the first EIS data and the second EIS data; and
generating a function representing a tendency between the angle parameter and the plurality of SOHs at the first temperature.
